# EUROPÄISCHE PATENTANMELDUNG

(11) **EP 2 378 846 A1**
(43) Veröffentlichungstag der Anmeldung: **19.10.2011**
(21) Anmeldenummer: 11151944.3
(22) Anmeldetag: 25.01.2011
(51) Int. Cl.: H05K 1/00, H05K 1/18, H05K 3/00, H05K 3/28, H05K 3/34, B29C 45/14

(54) **Dekorative Produktoberfläche mit Leiterplattenfunktion**

(71) Anmelder: Bayer Material Science AG, 51368 Leverkusen (DE)
(72) Erfinder: Die Erfindernennung liegt noch nicht vor

(57) **Zusammenfassung**

Die Erfindung betrifft ein Formbauteil (10, 10*) enthaltend eine mit einem Kunststoff (K) hinterspritzte Folie (1, 1*), wobei die Folie (1, 1*) zumindest einen Teil der Oberfläche des Formbauteils (10, 10*) bildet, wobei das Formbauteil (10, 10*) eine elektrische und/oder elektronische Schaltung mit einer Leiterbahnstruktur (2) und wenigstens einem mit der Leiterbahnstruktur (2) verbundenen elektrischen oder elektronischen Bauelement (2c) umfasst, und wobei die Folie (1, 1*) zumindest abschnittsweise elektrisch isolierend ist und das Trägermaterial für die Leiterbahnstruktur (2) und das wenigstens eine elektrische oder elektronische Bauelement (2c) bildet. Ferner betrifft die Erfindung ein Verfahren zur Herstellung eines solchen Formbauteils (10, 10*) sowie eine vorteilhafte Verwendung desselben.

## Beschreibung

Die vorliegende Erfindung betrifft ein Formbauteil umfassend eine elektrische und/oder elektronische Schaltung mit einer Leiterbahnstruktur und wenigstens einem elektrischen oder elektronischen Bauelement. Ferner betrifft die Erfindung ein Verfahren zum Herstellen eines solchen Formbauteils sowie eine bevorzugte Verwendung.

Insbesondere im Bereich der Bedienung komplexer technischer Geräte oder Maschinen besteht der Bedarf, elektronische Schaltungen in dreidimensionale Formbauteile zu integrieren, um somit komplexe, dreidimensional geformte Bedienelemente zu erhalten, mit welchen beispielsweise die Bedienung eines Fahrzeugs oder einer Maschine vereinfacht und intuitiver gestaltet werden kann. Ein typisches Beispiel hierfür sind aus der Praxis bekannte so genannte MID-Bauteile (Moulded interconnect Devices). Hierbei handelt es sich um spritzgegossene thermoplastische Bauteile mit einem integrierten Leiterbild, welches beispielsweise durch strukturiertes Metallisieren erreicht wird. Im Zuge des 3D-MID-Verfahrens werden die Strukturen für die Leiterbahnen direkt in die Oberfläche dreidimensionaler Schaltungsträger durch einen Laser eingraviert. Anschließend lassen sich diese sofort haftfest metallisieren. Elektronische Bauteile werden in einem nächsten Schritt dreidimensional gesetzt und gelötet. Gegenüber konventionellen 2D-Leiterplatten ergeben sich bei Anwendung der MID-Technologie Vorteile hinsichtlich Gestaltungsfreiheit, Reduzierungen von Montageprozessen sowie größerer Flexibilität bei Änderungen des Schaltungslayouts. MID-Entwicklungen stellen damit eine sinnvolle Technologie für dreidimensionale Komponenten in reduzierten Einbauräumen dar. Gleichwohl weisen die mittels MID hergestellten Bauteile eine noch zu hohe Komplexität auf, da neben den mit der Leiterbahnstruktur versehenen spritzgegossenen Bauteilen ein Gehäusekörper als äußerer Abschluss vorgesehen sein muss, welcher einen dauerhaften Schutz gegen Umwelteinflüsse sicherstellen sowie eine dekorative und ggf. mit Bedieninformationen versehene Oberfläche bereitstellen muss.

Hiervon ausgehend liegt der Erfindung die Aufgabe zugrunde, ein Formbauteil umfassend eine elektrische und/oder elektronische Schaltung mit einer Leiterbahnstruktur und wenigstens einem elektrischen oder elektronischen Bauelement anzugeben, welches sich durch eine im Vergleich zu bekannten Technologien reduzierte Komplexität, insbesondere durch eine reduzierte Teilezahl, auszeichnet, wobei die Oberfläche des Formbauteils funktional und/oder dekorativ gestaltbar sein soll. Ferner soll ein Verfahren zur Herstellung eines solchen Formbauteils sowie eine bevorzugte Verwendung angegeben werden.

Die Aufgabe wird erfindungsgemäß gelöst mit Formbauteil enthaltend eine mit einem Kunststoff hinterspritzte Folie, wobei die Folie zumindest einen Teil der Oberfläche des Formbauteils bildet, wobei das Formbauteil eine elektrische und/oder elektronische Schaltung mit einer Leiterbahnstruktur und wenigstens einem mit der Leiterbahnstruktur verbundenen elektrischen oder elektronischen Bauelement umfasst, und wobei die Folie zumindest abschnittsweise elektrisch isolierend ist und das Trägermaterial für die Leiterbahnstruktur und das wenigstens eine elektrische oder elektronische Bauelement bildet.

Vorteilhafte Ausgestaltungen des Formbauteils finden sich in den Ansprüchen 2-8.

Der besondere Vorteil des erfindungsgemäßen Formbauteils besteht darin, dass bisher separat vorzusehende Komponenten, nämlich Bauteilgehäuse, Platine sowie Platinenstützstruktur, in einem Bauteil integriert werden können. So kommt der hinterspritzten und mit einer elektrischen und/oder elektronischen Schaltung versehenen Folie einerseits die Funktion als dekorative und/oder funktionale Bauteiloberfläche zu. Andererseits übernimmt die hinterspritzte Folie auch die Funktion einer Platine mit Leiterbahnstruktur und Bauelementen und aufgrund der Kunststoffhinterspritzung die eines stützenden Strukturelements. Ferner dient die Folie als Isolation und Berührungsschutz. Durch die Hinterspritzung wird die elektrische oder elektronische Schaltung sicher versiegelt. Besonders vorteilhaft erweist sich die Verwendung des erfindungsgemäßen Formbauteils im Bereich besonders flacher Produkte, wo für gesonderte Platinen mit montierter Elektronik in der Höhe nur begrenzter Platz zur Verfügung steht. Ferner kann das erfindungsgemäße Formbauteil dann eingesetzt werden, wenn besondere Anforderungen an die Vibrationsfestigkeit gestellt werden. Auch lässt sich in dem erfindungsgemäßen Formbauteil eine hermetische Versiegelung der eingesetzten elektrischen/elektronischen Schaltung erreichen.

Aus dem Stand der Technik ist das Film-Insert-Molding (FIM) als ein Verfahren bekannt, um funktionale Folien, insbesondere dekorativ gestaltete Folien mit besonderen Oberflächeneigenschaften, wie Abrieb- oder Kratzfestigkeit, mit Kunststoff zu hinterspritzen und somit Formbauteile mit speziellen dekorativen Oberflächen zu schaffen. Wird das Folienhalbzeug im Vorfeld des Hinterspritzens umgeformt und geeignet beschnitten, sind auch dreidimensionale Formen mit großer Geometrievielfalt und Oberflächenqualität herstellbar. Ferner ist aus der WO2010/123733 A1 bekannt, eine Folien im Rahmen des Film-Insert-Molding-Verfahrens vor dem Hinterspritzen mit einer Antennenstruktur zu versehen, um beispielsweise eine in eine Gehäuseschale integrierte Antenne zu realisieren.

Bei der Folie handelt es sich erfindungsgemäß bevorzugt um eine Folie aus einem polymeren Kunststoff, beispielsweise aus Polycarbonat (PC), PC-Blend, Polyethylenterephthalat (PET), Polyimid (PI) oder Polyethylennaphthalat (PEN). Die Folie kann aus einem transparenten oder einem opaken Material gefertigt sein. Ist die Folie transparent, so kann sie bevorzugt auf ihrer Rückseite mit einer dekorativen Grafik bedruckt sein, um ein besonderes ästhetisches Erscheinungsbild (Klavierlackeffekt) zu erzeugen. Weitere grafische Gestaltungsmöglichkeiten bestehen in der Aufbringung eines Lackes mit Metallic- oder Carbonlook-Effekt. Um die für das Hinterspritzen und Bedrucken nötige Robustheit sicherzustellen, weist die Folie nach einer Ausgestaltung der Erfindung eine Dicke von 90 bis 1000 µm, bevorzugt von 175 bis 750 µm, besonders bevorzugt von 250 bis 500 µm aufweist auf.

Erfindungsgemäß ist die Folie des Formbauteils zumindest abschnittsweise elektrisch isolierend ausgebildet und bildet gleichzeitig das Trägermaterial für die Leiterbahnstruktur und das wenigstens eine elektrische oder elektronische Bauelement. Handelt es sich um eine PC-Folie, so wird die Leiterbahnstruktur bevorzugt durch Bedrucken mit Leitsilber im Siebdruckverfahren auf der Folienoberfläche erzeugt. Handelt es sich dagegen um eine PET-, PEN- oder PI-Folie, so erfolgt das Aufbringen der Leiterbahnstruktur bevorzugt mit einem lithographisch subtraktiven Ätzverfahren. Unter einer Leiterbahnstruktur im Sinne der vorliegenden Erfindung wird wenigstens eine, bevorzugt eine Mehrzahl von Leiterbahnen beliebiger Geometrie unter Einschluss auch zumindest abschnittsweise flächiger Strukturen verstanden.

Ferner kann die Folie wenigstens auf ihrer von der Leiterbahnstruktur abgewandten Seite wenigstens eine funktionale Beschichtung, insbesondere eine Kratzschutzbeschichtung, eine UV-Schutzbeschichtung, eine Soft-Touch-Beschichtung, d.h. eine Folienbeschichtung mit weicher Haptik, eine semitransparente Beschichtung, beispielsweise für spezielle Transparenzeffekte bei gleichzeitigem metallischen Glanz, oder eine Lackierung, aufweisen. Hierdurch kann neben einer Verbesserung des ästhetischen Erscheinungsbildes zusätzlich die Gebrauchsfähigkeit des Formbauteils durch eine entsprechende Schutzschicht gegen mechanische oder Umwelteinflüsse, insbesondere Strahlungseinflüsse, verbessert werden.

Das erfindungsgemäße Formbauteil kann im Wesentlichen zweidimensional, das heißt flächig ausgebildet sein. Nach einer weiteren vorteilhaften Ausgestaltung der Erfindung kann die Folie jedoch auch dreidimensional, insbesondere durch High-Pressure-Forming oder Tiefziehen, verformt sein. Durch die vorstehend genannten Umformprozesse wird eine sehr große Gestaltungsfreiheit in Bezug auf die Formbauteilgeometrie erreicht. Dabei erfolgt die Verformung bevorzugt vor dem Hinterspritzen, jedoch nach dem Aufbringen der Leiterbahnstruktur. Die Bestückung mit dem wenigstens einem elektrischen oder elektronischen Bauelement, kann geometrieabhängig vor oder nach dem Verformen erfolgen.

Erfindungsgemäß weist das Formbauteil eine Leiterbahnstruktur und wenigstens ein mit der Leiterbahnstruktur verbundenes elektrisches oder elektronisches Bauelement auf, wobei die Folie als Trägermaterial für die Leiterbahnstruktur fungiert. Das wenigstens eine Bauelement ist nach einer Ausgestaltung der Erfindung mittels Löten, speziell Niedertemperaturlöten oder Laserlöten, mit der Leiterbahnstruktur der Folie verbunden. Das Niedertemperaturlöten erfolgt bevorzugt mit niedrig schmelzenden bleifreien Loten, wie beispielsweise SnBi mit einem Schmelzpunkt von 138-142 °C. Ein weiteres geeignetes Fügeverfahren ist das elektrisch leitfähige Kleben. Bevorzugt wird hier ein elektrisch leitender isotroper oder anisotroper bei Kleber., wie z.B. Panacol Elecolit 3063, Threebond TB 3373 oder 3M 9703 verwendet. Diese Kleber härten durch Bestrahlung mit UV-Licht oder durch Druck, Temperatur oder Zeit bei Raumtemperatur aus. Ebenso möglich ist ein Bonden der Kontakte bevorzugt mittels Ultraschallschweißverfahren. Bei Einsatz einer der vorgenannten Niedertemperatur-Fügeverfahren wird eine Schädigung des Foliensubstrats der elektrischen und/oder elektronischen Schaltung minimiert.

Bei dem wenigstens einen elektrischen und/oder elektronischen Bauelement kann es sich prinzipiell um jedes Bauelement, welches Teil einer elektrischen oder elektronischen Schaltung sein kann, handeln. Insbesondere kann es sich um ein passives Bauelement, insbesondere einen Widerstand, einen Kondensator, eine Induktivität, einen Transformator oder einen Permanentmagnet handeln. Ferner kann es sich um eine elektrische Energiequelle, speziell eine Batterie oder eine Solarzelle, ein aktives Bauelement, insbesondere eine Diode, einen Transistor, ein Vierschicht-Bauelement, einen Diac, einen Triac oder einen Integrierter Schaltkreis, ein optoelektronisches Bauelement, insbesondere eine Laserdiode, eine Leuchtdiode oder einen Fotohalbleiter, einen Aktor oder einen Sensor handeln. Die Bestückung der Folie mit dem wenigstens einen Bauelement kann in einem bekannten Verfahren (automatisiert oder manuell) erfolgt sein.

Um die Stabilität des oder der mit der Leiterbahnstruktur verbundenen Bauelemente zu erhöhen und ihre Haftung auf der Leiterbahnstruktur zu verbessern, ist nach einer weiteren besonders vorteilhaften Ausgestaltung der Erfindung vorgesehen, dass das wenigstens eine elektrische oder elektronische Bauelemente mit einem Füllmaterial, insbesondere einem 1K- oder 2K-Klebharz, unterfüllt ist. Hierdurch wird erreicht, dass mechanische und Druckbelastungen des wenigstens einen Bauelements, welche insbesondere beim Hinterspritzen der Folie auftreten, nicht nur über die vergleichsweise empfindlichen Kontakte zwischen dem Bauelement und der Leiterbahnstruktur in diese abgeleitet werden, was bei zu großer Belastung zu einem Abreißen des Bauelements von der Leiterbahnstruktur führen könnte. Alternativ oder ergänzend zu der Unterfüllung des wenigstens einen Bauelements kann dieses zusammen mit der Leiterbahnstruktur durch eine Vergussmasse, beispielsweise ein 1K-Epoxidharz (z. B. Glob-Top der Panacol-Elosol GmbH) versiegelt sein.

Erfindungsgemäß ist die die elektrische oder elektronische Schaltung tragende Folie mit einem Kunststoff hinterspritzt. Dies kann im Film-Insert-Molding (FIM) Verfahren erfolgt sein, bei dem ein thermoplastischer Kunststoff in plastifizierter Form in ein Spritzgießwerkzeug, in welchem die zu hinterspritzende Folie positioniert ist, unter hohem Druck und hoher Temperatur einströmt, dort erkaltet und dabei zu einem Formkörper erstarrt. Hierzu sind sämtliche für das Spritzgießen geeigneten plastifizierbaren Materialien verwendbar. Bevorzugt ist dies ein Kunststoff ausgewählt aus der Gruppe PC, ABS, TPU. Falls sich die Druck- oder Temperaturbelastung des wenigstens einen elektrischen oder elektronischen Bauelements im Zuge des Einspritzens der Schmelze als zu hoch erweist, kann alternativ zum Einspritzen einer heißen Kunststoffschmelze ein niederviskoses 2-Komponentengemisch unter vergleichsweise geringem Druck und bei Normaltemperatur in das Spritzgießwerkzeug eingespritzt werden, wo das Gemisch dann in einer chemischen Reaktion zwischen den Komponenten aushärtet. Für diese als Reaction-Injection-Molding (RIM) bezeichnete Verfahrensvariante eignet sich insbesondere PU, dessen Ausgangsstoffe Polyol und Polyisocyanat vor dem Einspritzen in das Spritzgießwerkzeug intensiv gemischt werden. Der besondere Vorteil des RIM-Verfahrens besteht auch darin, dass infolge der geringen Viskosität des eingespritzten Gemischs auf eine Unterfüllung des Bauelements verzichtet werden kann.

Infolge des Hinterspritzens der mit der Leiterbahnstruktur und dem wenigstens einen Bauelement versehenen Folie kann zumindest ein Teil der elektrischen und/oder elektronischen Schaltung nicht mehr für eine externe Kontaktierung zugänglich sein. Daher ist es besonders vorteilhaft, wenn die elektrische oder elektronische Schaltung wenigstens eine extern zugängliche Schnittstelle, insbesondere einen Stecker, ein Buchse oder eine kapazitive, induktive oder optische Schnittstelle, zur Anbindung der elektrischen und/oder elektronischen Schaltung an eine Energieversorgung und/oder eine integrierte Elektronik aufweist. Dieser ist beim Hinterspritzen der Folie durch das Werkzeug selbst oder ein weiteres Hilfsmittel derart freizustellen, dass sich keine Schmelze auf der Schnittstelle absetzen kann.

Die eingangs erwähnte Aufgabe wird auch durch ein Verfahren zum Herstellen eines Formbauteils nach einem der Ansprüche 1-8 gelöst, wobei das Verfahren folgende Schritte umfasst:
- Bereitstellen einer zumindest abschnittsweise isolierenden Folie
- Aufbringen einer Leiterbahnstruktur auf wenigstens eine Folienfläche,
- Bestücken der Leiterbahnstruktur mit wenigstens einem elektrischen oder elektronischen Bauelement
- Zumindest abschnittsweises Hinterspritzen der Folie.

Vorteilhafte Ausgestaltungen des Verfahrens finden sich in den Ansprüchen 10-14. Hinsichtlich der Vorteile des erfindungsgemäßen Verfahrens und seiner Ausgestaltungen geht das vorstehend Gesagte entsprechend.

Ein weiterer Aspekt der Erfindung betrifft die Verwendung eines Formbauteils nach einem der Ansprüche 1 bis 8 in einem Unterwassermodul mit hohen Anforderungen an die hermetische Versiegelung der Elektronik, sowie bei hohen Anforderungen an die Vibrationsfestigkeit, Zuverlässigkeit und Ausfallsicherheit.

Im Folgenden wird die Erfindung anhand einer ein Ausführungsbeispiel darstellenden Zeichnung näher erläutert. Es zeigen:
- Fig. 1: eine transparente, rückseitig dekorativ bedruckte Folie in Vorderansicht und in Schnittansicht,
- Fig. 2: die Folie aus Fig. 1 mit Leiterbahnen und Lötpads in rückwärtiger Draufsicht und in Schnittansicht,
- Fig. 3: die Folie aus Fig. 2 mit aufgelöteten SMD-Bauteilen und einem mehrpoligen Stecker in rückwärtiger Draufsicht und in Schnittansicht,
- Fig. 4: die Folie aus Fig 3 nach teilweiser dreidimensionaler Verformung in seitlicher Schnittansicht,
- Fig. 5: die Folie aus Fig. 4 eingelegt in ein Spritzgießwerkzeug in seitlicher Schnittansicht,
- Fig. 6: die Folie und das Spritzgießwerkzeug der Ansicht der Fig. 5 mit geschlossenem Spritzgießwerkzeug,
- Fig. 7: die Folie und das Spritzgießwerkzeug der Ansicht der Fig. 6 nach Einströmen der Kunststoffschmelze oder PU-Gießmasse,
- Fig. 8: die Folie und das Spritzgießwerkzeug der Ansicht der Fig. 7 nach Öffnen des Spritzgießwerkzeugs,
- Fig. 9: das entformte Formbauteil mit Anguss in Vorderansicht, Rückansicht und Seitenansicht und
- Fig. 10: das entformte Bauteil der Fig. 9 mit entferntem Anguss in Vorderansicht, Rückansicht und Seitenansicht.

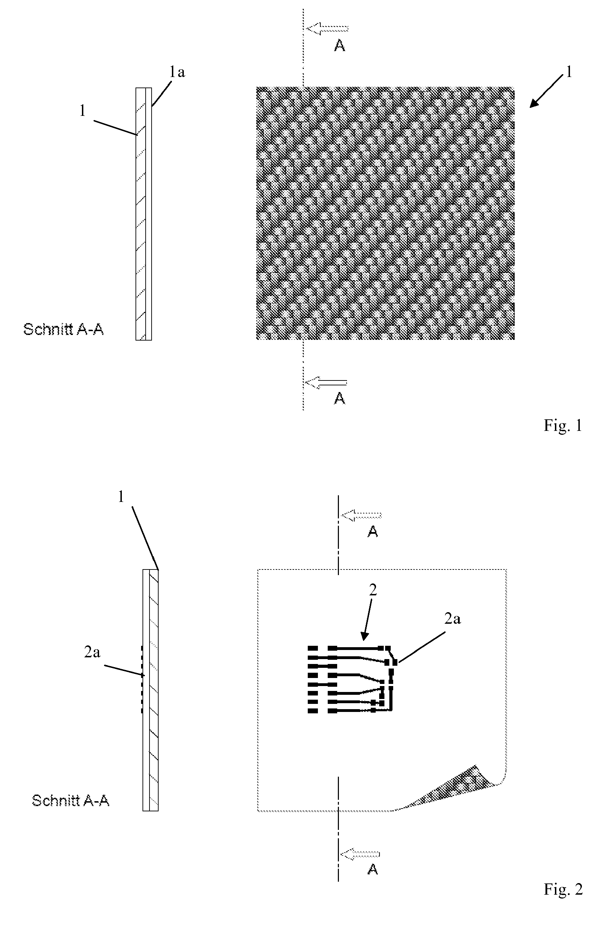

Figur 1 zeigt eine transparente, rückseitig dekorativ bedruckte Folie 1 in Vorderansicht und den Schnittansicht. Sie bildet den Ausgangspunkt für die Herstellung eines Formbauteils, dessen Oberfläche zumindest teilweise durch die Folie 1 gebildet wird, wobei die Folie1 mit einem Kunststoff hinterspritzt ist. Bei der Folie 1 handelt es sich bevorzugt um eine Folie aus einem polymeren Kunststoff, beispielsweise aus Polycarbonat (PC), PC-Blend, Polyethylenterephthalat (PET), Polyimid (PI) oder Polyethylennaphthalat (PEN). Vorliegend ist die Folie transparent und auf ihrer Rückseite mit einer dekorativen Grafik bedruckt. Hierdurch wird ein besonderes ästhetisches Erscheinungsbild (Klavierlackeffekt/Hinterglas-Effekt) erzeugt.

In der Schnittansicht der Figur 1 ist die transparente Folie 1 schraffiert dargestellt, während die mehrlagige Druckschicht 1a ohne Schraffur dargestellt ist.

Figur 2 zeigt die Rückseite der dekorativ bedruckten Folie mit einer aufgedruckten Leiterbahnstruktur 2 und Löt- oder Bondpads 2a. Auf die Löt-/Bondpads 2a können Bauelemente (in Figur 2 nicht dargestellt), insbesondere SMD-Bauelemente, aufgelötet bzw. aufgebonded werden. Die aufgedruckte Leiterbahnstruktur 2 kann prinzipiell beliebige Geometrien aufweisen. Ebenso können zumindest abschnittsweise flächige Bereiche vorgesehen sein. Das Aufbringen der Leiterbahnstruktur kann je nach verwendetem Folienmaterial beispielsweise durch Bedrucken mit Leitsilber im Siebdruckverfahren (bevorzugt im Falle von PC-Folien) oder mit einem lithographisch subtraktiven Ätzverfahren (bevorzugt bei PET-, PEN- oder PI-Folien) erfolgt sein.

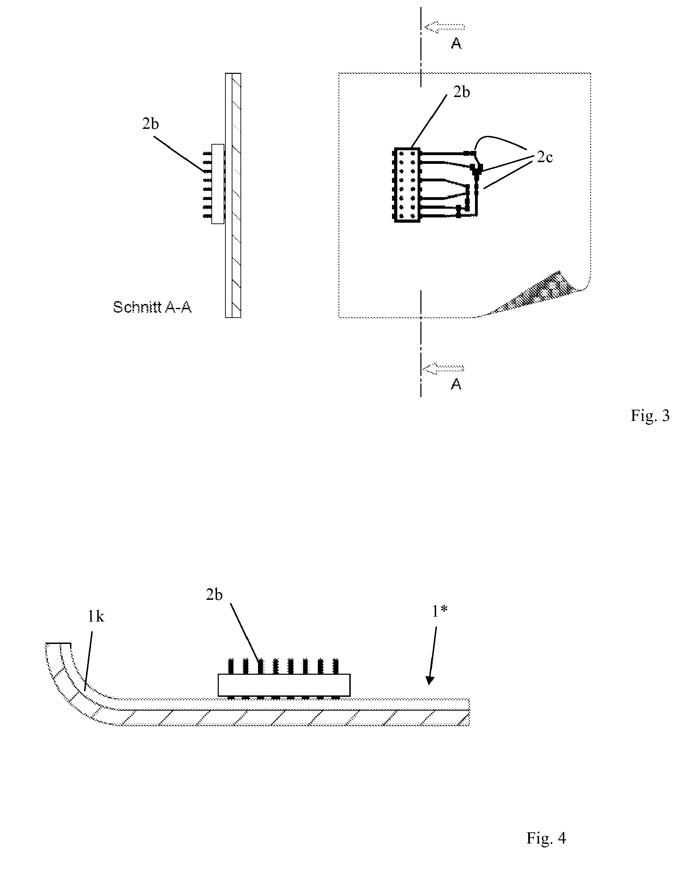

Die in Figur 3 gezeigte Folie 1 unterscheidet sich von der aus Figur 2 dadurch, dass eine mit der Leiterbahnstruktur 2 verbundene extern zugängliche Schnittstelle, vorliegend ein Stecker 2b, vorgesehen ist, über welche die Leiterbahnstruktur 2 mit externen Schaltungen (nicht dargestellt), beispielsweise einer Strom-/Spannungsquelle oder einem integrierten Schaltkreis, verbunden werden kann. Wie in Figur 3 dargestellt, sind bei der Leiterbahnstruktur 2 SMD-Bauelemente 2c auf die Lötpads 2a der Leiterbahnstruktur 2 aufgelötet. Bei den SMD-Bauelementen 2c kann es sich um passive Bauelemente, insbesondere einen Widerstand, einen Kondensator, eine Induktivität, einen Transformator oder einen Permanentmagnet handeln. Ferner kann es sich um eine elektrische Energiequelle, speziell eine Batterie oder eine Solarzelle, ein aktives Bauelement, insbesondere eine Diode, einen Transistor, ein Vierschicht-Bauelement, einen Diac, einen Triac oder einen Integrierter Schaltkreis, ein optoelektronisches Bauelement, insbesondere eine Laserdiode, eine Leuchtdiode oder einen Fotohalbleiter, einen Aktor oder einen Sensor handeln.

Wie in der seitlichen Schnitt Ansicht der Figur 4 nun dargestellt, ist die Folie 1* nach dem Aufbringen der Leiterbahnstruktur 2 und der Bestückung mit den SMD-Bauelementen 2c und dem Stecker 2b in einem Teilbereich 1k dreidimensional verformt. Die Verformung kann durch ein thermisches Tiefziehverfahren oder durch das High-Pressure-Forming Verfahren (HPF) erfolgt sein. Die Verformung kann auch in dem Bereich der Leiterbahnstruktur 2 erfolgen. Ist die Bestückung mit elektrischen Bauelementen 2c in dem verformten Bereich 1k vorgesehen, so werden die Bauelemente 2c bevorzugt nach der Verformung aufgebracht.

Nicht dargestellt ist eine weiterer Verfahrensschritt, welcher vor oder nach der dreidimensionalen Verformung erfolgen kann und wonach die Bauelemente 2c mit einem Füllmaterial, insbesondere einem 1K- oder 2K-Klebharz, unterfüllt werden, um die Stabilität des oder der mit der Leiterbahnstruktur 2 verbundenen Bauelemente 2c zu erhöhen und ihre Haftung auf der Leiterbahnstruktur 2 zu verbessern. Alternativ oder ergänzend zu der Unterfüllung der Bauelemente 2c können diese zusammen mit der Leiterbahnstruktur durch eine Vergussmasse, beispielsweise ein 1K-Epoxidharz (z. B. Glob-Top der Panacol-Elosol GmbH) versiegelt sein (ebenfalls nicht dargestellt).

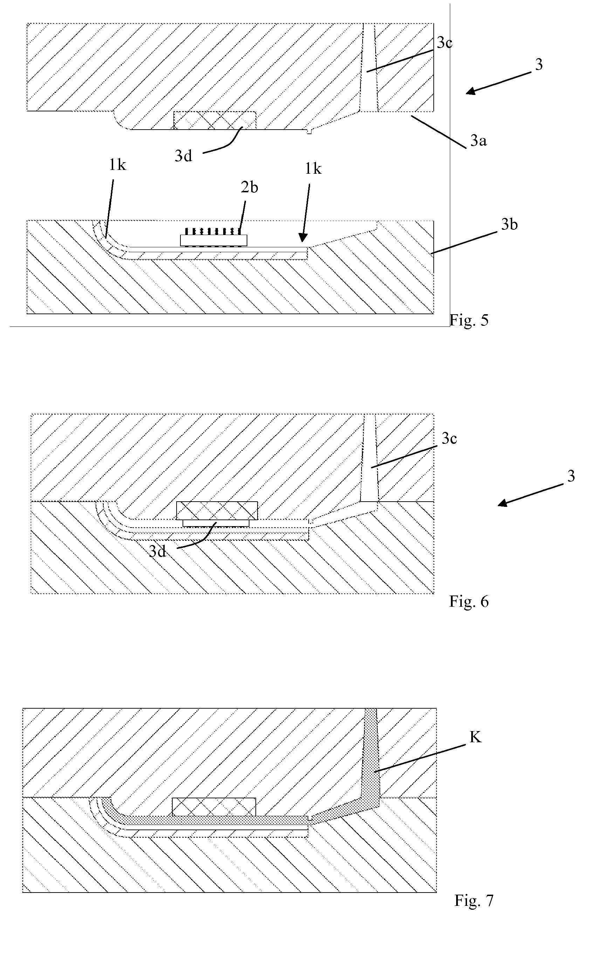

Nachdem die Vorbereitung der Folie 1* durch Aufbringen der Druckschicht 1a, der Leiterbahnstruktur 2 und der Lötpads 2a, des Steckers 2b sowie der Bauelemente 2c vorbereitet und anschließend unter Ausbildung des dreidimensional verformten Bereiches 1k verformt ist, kann die Fertigstellung des Formbauteils durch Hinterspritzen der Folie 1*, vorliegend im Film-Insert-Molding-Verfahren (FIM), erfolgen. Wie in Fig. 5 dargestellt, wird hierzu die verformte Folie 1* in die Unterform 3b eines Spritzgießwerkzeugs 3 eingelegt, wo sie formschlüssig anliegt. Die mit den Bauelementen 2c und dem Stecker 2b bestückte Seite der Folie 1* ist dabei von der Werkzeugwand abgewandt.

Wie in Fig. 6 gezeigt, wird anschließend das Spritzgießwerkzeug 3 durch Absenken seiner Oberform 3a geschlossen, wobei die freizustellenden Kontakte des Steckers 2b mit einem elastischen Einlegeteil 3d abgedeckt werden (gekreuzt-schraffiert dargestellt), um eine Überdeckung mit der einzuspritzenden Kunststoffmasse zu verhindern. Der Stecker 2b wird dadurch auch noch zusätzlich in dem Spritzgießwerkzeug 3 fixiert.

Gemäß Fig. 7 wird nach dem Schließen des zweiteiligen Spritzgießwerkzeugs 3 der Kunststoff K über einen Angusskanal 3c in die Werkzeugkavität eingespritzt. Bei dem Kunststoff K handelt es sich um einen thermoplastischer Kunststoff (z.B. PC, ABS, TPU), welcher in plastifizierter Form eingespritzt wird. Falls sich die Druck- oder Temperaturbelastung der Bauelemente 2c oder des Steckers 2b im Zuge des Einspritzens der Schmelze als zu hoch erweist, kann alternativ ein niederviskoses 2-Komponentengemisch unter vergleichsweise geringem Druck und bei Normaltemperatur in das Spritzgießwerkzeug eingespritzt werden, wo das Gemisch dann in einer chemischen Reaktion zwischen den Komponenten aushärtet (Reaction-Injection-Molding). Durch die Kunststoffmasse werden die Bauelemente 2c und zum Teil auch der Stecker 2b umschlossen und versiegelt.

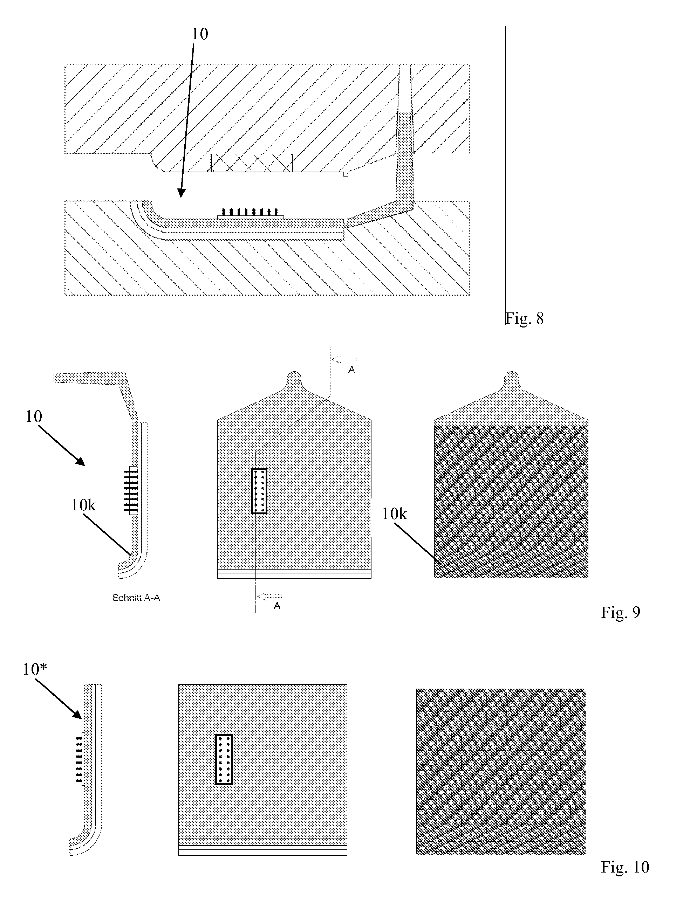

Wie in Fig. 8 dargestellt, kann das Formbauteil 10 umfassend die dekorativ bedruckte, verformte Folie 1*, die Bauelemente 2c samt Stecker 2b sowie die fest mit der Folie 1* verbundene

Formmasse K, nach dem Erstarren (bzw. dem Vernetzen der Formmasse im Falle von RIM) entformt werden. Hierzu wird die Oberform 3a des Spritzgießwerkzeugs 3 angehoben, wobei das elastische Einlegeteil 3d, das während des Einspritzens der Kunststoffmasse K den Stecker 2b abgedeckt hat, in der Oberform 3a verbleibt.

Fig. 9 zeigt nun das fertig entformte Formbauteil 10 in seitlicher Schnittansicht (links) gemäß Schnittlinie A-A, in Rückansicht mit aus der erstarrten bzw. vernetzten Kunststoffmasse K herausragenden Stecker 2b (Mitte) sowie in Vorderansicht mit der dekorativen Bedruckung (rechts). Wie in Fig. 9 Mitte erkennbar, ist die Leiterbahnstruktur 2 mit den Bauelementen 2c durch Kunststoffmasse K vollständig abgedeckt.

Fig. 10 zeigt das fertige Formbauteil 10* mit nunmehr entferntem Anguss.

## Patentansprüche

1. Formbauteil (10, 10*) enthaltend eine mit einem Kunststoff (K) hinterspritzte Folie (1, 1*), wobei die Folie (1, 1*) zumindest einen Teil der Oberfläche des Formbauteils (10, 10*) bildet,
- wobei das Formbauteil (10, 10*) eine elektrische und/oder elektronische Schaltung mit einer Leiterbahnstruktur (2) und wenigstens einem mit der Leiterbahnstruktur verbundenen elektrischen oder elektronischen Bauelement (2c) umfasst, und
- wobei die Folie (1, 1*) zumindest abschnittsweise elektrisch isolierend ist und das Trägermaterial für die Leiterbahnstruktur und das wenigstens eine elektrische oder elektronische Bauelement (2c) bildet.

2. Formbauteil (10, 10*) nach Anspruch 1,
**dadurch gekennzeichnet, dass**
die Folie (1, 1*) eine Dicke von 90 bis 1000 µm, bevorzugt von 175 bis 500 µm, besonders bevorzugt von 250 bis 500 µm aufweist.

3. Formbauteil (10, 10*) nach Anspruch 1 oder 2,
**dadurch gekennzeichnet, dass**
die Folie (1*) dreidimensional, insbesondere durch High-Pressure-Forming oder Tiefziehen, verformt ist.

4. Formbauteil (10, 10*) nach einem der Ansprüche 1 bis 3,
**dadurch gekennzeichnet, dass**
die Folie (1, 1*) auf ihrer von der Leiterbahnstruktur (2) abgewandten Seite wenigstens eine funktionale Beschichtung, insbesondere eine Kratzschutzbeschichtung, eine UV-Schutzbeschichtung, eine Soft-Touch-Beschichtung, eine semitransparente Beschichtung oder eine Lackierung, aufweist.

5. Formbauteil (10, 10*) nach einem der Ansprüche 1 bis 4,
**dadurch gekennzeichnet, dass**
das wenigstens eine elektrische oder elektronische Bauelement (2c) mittels Löten, speziell Niedertemperaturlöten oder Laserlöten, oder elektrisch leitfähiges Kleben mit der Leiterbahnstruktur (2) der Folie (1, 1*) verbunden ist.

6. Formbauteil (10, 10*) nach einem der Ansprüche 1 bis 5,
**dadurch gekennzeichnet, dass**
das wenigstens eine elektrische oder elektronische Bauelement (2c) mit einem Füllmaterial, insbesondere einem 1K- oder 2K-Klebharz, unterfüllt ist.

7. Formbauteil (10, 10*) nach einem der Ansprüche 1 bis 6,
**dadurch gekennzeichnet, dass**
der hinterspritzte Kunststoff (K) ausgewählt ist aus der Gruppe PC, ABS, TPU oder PU.

8. Formbauteil (10, 10*) nach einem der Ansprüche 1 bis 7,
**dadurch gekennzeichnet, dass**
die elektrische oder elektronische Schaltung wenigstens eine extern zugängliche Schnittstelle (2b), insbesondere einen Stecker, eine Buchse oder eine kapazitive, induktive oder optische Schnittstelle, zur Anbindung der elektrischen und/oder elektronischen Schaltung an eine Energieversorgung und/oder eine integrierte Elektronik aufweist.

9. Verfahren zum Herstellen eines Formbauteils (10, 10*) nach einem der Ansprüche 1 bis 8, umfassend folgende Schritte:
- Bereitstellen einer zumindest abschnittsweise isolierenden Folie (1, 1*),
- Aufbringen einer Leiterbahnstruktur (2) auf wenigstens eine Folienfläche,
- Bestücken der Leiterbahnstruktur (2) mit wenigstens einem elektrischen oder elektronischen Bauelement (2c)
- Zumindest abschnittsweises Hinterspritzen der Folie (1, 1*).

10. Verfahren nach Anspruch 9,
**dadurch gekennzeichnet, dass**
die Leiterbahnstruktur (2) durch Siebdruck oder durch ein lithographisches subtraktives Ätzverfahren aufgetragen wird.

11. Verfahren nach Anspruch 9 oder 10,
das wenigstens eine elektrische oder elektronische Bauelement (2c) mittels Löten, speziell Niedertemperaturlöten oder Laserlöten, oder elektrisch leitfähiges Kleben mit der Leiterbahnstruktur (2) der Folie verbunden wird.

12. Verfahren nach einem der Ansprüche 9 bis 11,
**dadurch gekennzeichnet, dass**
die Folie (1, 1*) vor dem Hinterspritzen dreidimensional, insbesondere durch High-Pressure-Forming oder Tiefziehen, verformt wird.

13. Verfahren nach einem der Ansprüche 9 bis 12,
**dadurch gekennzeichnet, dass**
das wenigstens eine elektrische oder elektronische Bauelement (2c) vor dem Hinterspritzen mit einem Füllmaterial, insbesondere einem 1K- oder 2K-Klebharz, unterfüllt ist.

14. Verfahren nach Anspruch 12 und 13,
**dadurch gekennzeichnet, dass**
das Unterfüllen und/oder Vergießen der Leiterbahnstruktur (2) und des wenigstens einen elektrischen oder elektronischen Bauelements (2c) mit einer flexiblen Unterfüllung oder Vergussmasse und vor dem dreidimensionalen Verformen erfolgt.

15. Verwendung eines Formbauteils nach einem der Ansprüche 1 bis 8 in einem Unterwassermodul
